# EUROPEAN PATENT APPLICATION

(11) **EP 4 764 025 A1**
(43) Date of publication of application: **24.06.2026**
(21) Application number: 24856261.3
(22) Date of filing: 04.08.2024
(51) Int. Cl.: C23C 14/08, C23C 14/34, C23C 14/56

(54) **GLASS FILM WITH NEAR-INFRARED BLOCKING FILM, NEAR-INFRARED BLOCKING FILM LAMINATE, METHOD FOR MANUFACTURING GLASS FILM WITH NEAR-INFRARED BLOCKING FILM, AND METHOD FOR MANUFACTURING NEAR-INFRARED BLOCKING FILM LAMINATE**

(30) Priority: 18.08.2023 JP 2023133471
(71) Applicant: SUMITOMO METAL MINING CO., LTD., Tokyo 105-8716 (JP)
(72) Inventor: OKAMI, Hideharu, Tokyo 1058716 (JP); ADACHI, Kenji, Tokyo 1058716 (JP)
(74) Representative: TBK
(86) International application number: PCT/JP2024/027830
(87) International publication number: WO 2025/041569

(57) **Abstract**

To provide a method capable of efficiently manufacturing a composite tungsten oxide film (electrically insulating heat ray shielding film) and a glass film with a near-infrared blocking film obtained by this method.

Glass films with near-infrared blocking films 101A and 102A are composed of glass films 101 and 102 having a thickness of 200 µm or less, and near-infrared blocking films 103 and 104 formed on one side of the glass films and made of composite tungsten oxide having a hexagonal crystal structure represented by the general formula MxWyOz, and are characterized in that the maximum value of transmittance in a visible light region of a wavelength of 380 nm or more and 780 nm or less of the near-infrared blocking films is 50 or more, and reflectance at a wavelength of 1400 nm of the near-infrared blocking films is 30% or more. Further, a near-infrared blocking film laminate 100A formed by bonding the glass film with a near-infrared blocking film to plate glass 100 or the like can be used for windows of automobiles and buildings where heat ray shielding properties and radio wave transparency are required.

## Description

### TECHNICAL FIELD

The present invention relates to a glass film with a near-infrared blocking film and a near-infrared blocking film laminate that transmit light in the visible wavelength region and reflect and block light in the near-infrared region, as well as a method for manufacturing the glass film with a near-infrared blocking film and a method for manufacturing the near-infrared blocking film laminate.

### BACKGROUND ART

Window members such as plate glass provided with a film that transmits visible light and blocks near-infrared rays, which become heat rays, are used for windows of automobiles, windows of buildings, and the like. Such a window member includes, on the surface of a transparent base material such as plate glass, a near-infrared blocking film in which an infrared absorbing material fine particle dispersion is provided, the dispersion containing fine particles of an infrared absorbing material such as cesium tungsten bronze dispersed in a resin transparent to visible light. Patent Literature 1 discloses an infrared absorbing material fine particle dispersion in which composite tungsten oxide particles are dispersed in a medium such as a resin.

However, since the above-mentioned near-infrared blocking film disclosed in Patent Literature 1 is formed by a coating method using a dispersion liquid of infrared absorbing material fine particles, advanced coating technology was required to ensure control of film thickness, uniformity of film thickness over a large area, and flatness.

Therefore, instead of the coating method, there is a technology of forming a near-infrared blocking film by depositing a near-infrared blocking material on a glass plate by sputtering or the like. Patent Literature 2 discloses an infrared reflective film in which a plurality of metal layers of different metals formed by sputtering and dielectric layers are laminated.

However, when a metal is formed into a film by sputtering, the film exhibits conductivity, and if used for a window material, it blocks radio waves between the outdoors and the indoors. Radio waves for wireless communication and FM radio are in the VHF band (30 MHz - 0.3 GHz). Radio waves for mobile phones and mobile communications belong to the UHF band (0.3 GHz - 3 GHz). Particularly useful communication radio waves are in the 0.9 GHz to 2.2 GHz range, and radio waves used for wireless LAN (wireless local area network) are in the 2.45 GHz band and 5.2 GHz band. For high-speed data communication and satellite communication, technology development for the SHF band (3 GHz - 30 GHz) having even shorter wavelengths is being conducted. It is preferable that radio waves in these frequency bands be transmissible. However, since an infrared reflective film (heat ray reflective film) made of a metallic thin film reflects radio waves in the GHz band and MHz band used for these signal transmissions, measures such as providing a cutout in a part of the film must be taken.

The reflectivity for radio waves in the MHz band and GHz band has a close relationship with the surface resistance value of the film. Generally, the larger the surface resistance value, the better the radio wave transparency. When the surface resistance value becomes 10⁵ Ω/□ (ohms per square) or more, considerable transparency occurs in the VHF band and UHF band; if the surface resistance value becomes 10⁶ Ω/□ or more, radio wave transparency almost equivalent to that of float glass can be obtained over the entire VHF, UHF, and SHF bands (Non-Patent Literature 1). Therefore, to ensure the transparency of radio wave signals, a high resistance of at least 10⁵ Ω/□ or more, preferably 10⁶ Ω/□ or more, as a surface resistance value is required (Non-Patent Literature 1).

Patent Literature 3 discloses a composite tungsten oxide film (electrically insulating heat ray shielding film) which is formed by sputtering similarly to Patent Literature 2, has a sheet resistance of 10⁵ Ω/□ or more, and has an absorptance of 35% or more at a wavelength of 1400 nm. With the spread of electric vehicles, a heat ray shielding function for reducing air conditioning load and increasing cruising range is becoming essential, but at the same time, with the improvement of comfort in automobiles and the shift to automated driving, transparency for various sensor signals is also required for automobile windows, so the composite tungsten oxide film (electrically insulating heat ray shielding film) disclosed in Patent Literature 3 is attracting attention.

Incidentally, when attempting to obtain the performance of an electrically insulating and transparent heat ray shielding film by sputtering deposition using a composite tungsten oxide material such as cesium tungsten bronze as a target, it is necessary to heat the base material, which is the object of film formation, to 300°C or higher during sputtering deposition, or to anneal at a temperature of 300°C or higher after sputtering deposition to crystallize the sputtering film (composite tungsten oxide film). For this reason, plate glass capable of withstanding heat during sputtering deposition or annealing treatment is used for the base material which is the object of film formation.

However, when plate glass is used for the base material, it is difficult to wind the plate glass into a roll shape and continuously convey it by a roll-to-roll method, so there was a problem that the composite tungsten oxide film (electrically insulating heat ray shielding film) could not be manufactured efficiently.

### CITATION LIST

### PATENT LITERATURES

Patent Literature 1: WO 2005/037932
Patent Literature 2: Japanese Unexamined Patent Application Publication No. 2006-117482
Patent Literature 3: Japanese Patent No. 6540859

### Non-Patent Literatures

Non-Patent Literature 1: Hiroshi ITO, Keisuke TANAKA, Yuji YAMAMOTO, Yasuo HASHIMOTO, Hiroshi KURIHARA, "Improvement of TV Radio Wave Reflecting Characteristics in High Performance Heat-Reflective Glass," ITE Technical Report, Vol. 15, pp. 15-21, 1991.

### SUMMARY OF THE INVENTION

### TECHNICAL PROBLEM

The present invention has been made focusing on such problems, and an object thereof is to provide a method capable of efficiently manufacturing a composite tungsten oxide film (electrically insulating heat ray shielding film), and a glass film with a near-infrared blocking film obtained by this manufacturing method.

More specifically, an object is to provide a method for manufacturing a glass film with a near-infrared blocking film in which a glass film is applied instead of plate glass as the base material, and a composite tungsten oxide film (electrically insulating heat ray shielding film) is formed by heating deposition or annealed after non-heating deposition by unit such as sputtering on the glass film continuously conveyed by a roll-to-roll method, and to provide a glass film with a near-infrared blocking film obtained by this manufacturing method, as well as to provide a near-infrared blocking film laminate formed by laminating this glass film with a near-infrared blocking film onto a transparent substrate such as plate glass or a polycarbonate plate, and a manufacturing method thereof.

### SOLUTION TO PROBLEM

That is, a first invention according to the present invention is
a glass film with a near-infrared blocking film, comprising:
a glass film having a thickness of 200 µm or less; and
a near-infrared blocking film formed on at least one side of the glass film and made of a composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) and having a hexagonal crystal structure,
characterized in that the maximum value of transmittance in a visible light region of a wavelength of 380 nm or more and 780 nm or less of the near-infrared blocking film is 5% or more, and reflectance at a wavelength of 1400 nm of the near-infrared blocking film is 30% or more.

Further, a second invention according to the present invention is
the glass film with a near-infrared blocking film described in the first invention,
characterized in that a film thickness of the near-infrared blocking film is 10 nm or more and 500 nm or less;
a third invention is
the glass film with a near-infrared blocking film described in the first invention or the second invention,
characterized in that a surface resistance value of the near-infrared blocking film is 10⁵ Ω/□ (ohms per square) or more;
a fourth invention is
the glass film with a near-infrared blocking film described in the first invention,
characterized in that a bonding layer is formed on a surface of the near-infrared blocking film; and
a fifth invention is
the glass film with a near-infrared blocking film described in the fourth invention,
characterized in that the bonding layer is composed of an oxide selected from SiO₂, Al₂O₃, ZrO₂, TiO₂, and HfO₂.

Next, a sixth invention according to the present invention is
a near-infrared blocking film laminate, comprising:
a transparent substrate that transmits visible light; and
the glass film with a near-infrared blocking film described in the first invention or the fourth invention laminated on the transparent substrate; and
a seventh invention is
the near-infrared blocking film laminate described in the sixth invention,
characterized in that the transparent substrate is composed of an inorganic material selected from plate glass or transparent ceramics, or an organic material selected from a resin film or a resin plate.

Furthermore, an eighth invention according to the present invention is
a method for manufacturing the glass film with a near-infrared blocking film described in the first invention,
comprising:
   a glass film unwinding step of unwinding a glass film having a thickness of 200 µm or less wound around an unwinding roll;
   a film forming step of forming a film of composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) on at least one surface of the glass film by a film forming unit while conveying the glass film unwound from the unwinding roll by a roll-to-roll method; and
   a heat treatment step of heat-treating the glass film on which the composite tungsten oxide is formed at a temperature equal to or lower than a strain point of the glass film to form a near-infrared blocking film made of composite tungsten oxide having a hexagonal crystal structure;
   a ninth invention is
   the method for manufacturing a glass film with a near-infrared blocking film described in the eighth invention,
   characterized in that, in the heat treatment step, heat treatment is sequentially performed using a plurality of heat treatment units on the glass film on which the composite tungsten oxide is formed, and a first heat treatment unit is composed of an infrared heater that emits infrared rays having a wavelength of 1500 nm or more;
   a tenth invention is
   the method for manufacturing a glass film with a near-infrared blocking film described in the ninth invention,
   characterized in that the first heat treatment unit is composed of a carbon heater or a SiC heater;
   further, an eleventh invention according to the present invention is
   a method for manufacturing the near-infrared blocking film laminate described in the sixth invention,
   comprising a thermocompression bonding step of thermocompression bonding the glass film with a near-infrared blocking film described in the first invention or the fourth invention and the transparent substrate composed of the organic material described in the seventh invention; and
   a twelfth invention is
   the method for manufacturing the near-infrared blocking film laminate described in the sixth invention,
   comprising a surface activation step of activating at least one surface of the glass film with a near-infrared blocking film described in the first invention or the fourth invention and the transparent substrate composed of the inorganic material described in the seventh invention, and a bonding step of bonding the glass film with a near-infrared blocking film and the transparent substrate via the activated surface.

### EFFECTS OF THE INVENTION

According to the glass film with a near-infrared blocking film and the manufacturing method thereof according to the present invention, since a glass film having a thickness of 200 µm or less is applied to a base material on which a near-infrared blocking film made of a composite tungsten oxide having a hexagonal crystal structure is formed, it becomes possible to wind the glass film into a roll shape and perform continuous conveyance by a roll-to-roll method; thus, there is an effect that a composite tungsten oxide film functioning as a heat ray shielding film can be efficiently manufactured.

### BRIEF DESCRIPTION OF DRAWINGS

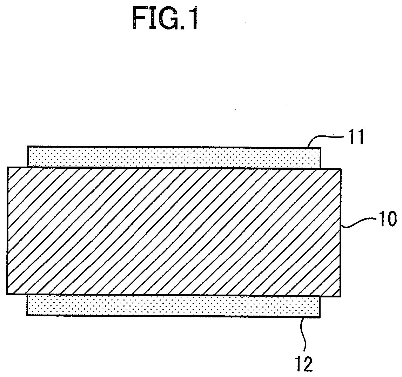

FIG. 1 is a configuration explanatory diagram of a near-infrared blocking film laminate according to a conventional example in which plate glass 10 is applied as a base material and near-infrared blocking films 11 and 12 are formed on both surfaces thereof.

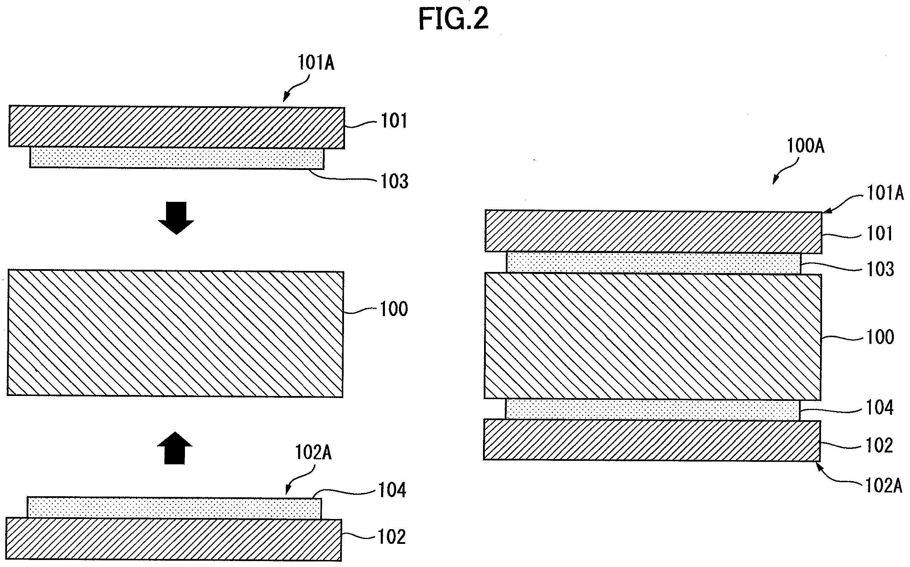

FIG. 2 shows each configuration explanatory diagram of glass films with near-infrared blocking films 101A and 102A according to the present embodiment in which glass films 101 and 102 are applied as base materials and near-infrared blocking films 103 and 104 are formed on one surface thereof, a transparent substrate 100, and a near-infrared blocking film laminate 100A according to the present embodiment in which the respective glass films with near-infrared blocking films 101A and 102A are bonded to both surfaces of the transparent substrate 100.

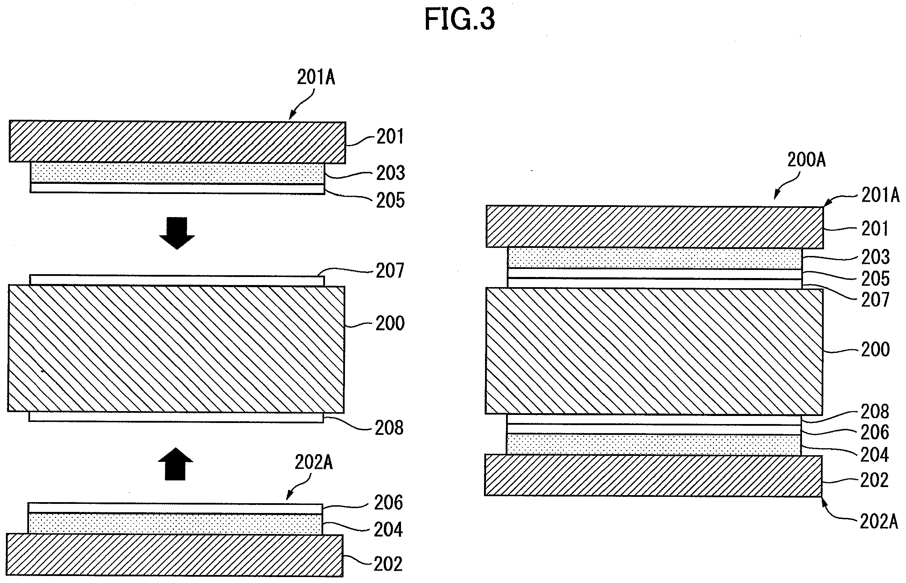

FIG. 3 shows each configuration explanatory diagram of glass films with near-infrared blocking films 201A and 202A according to the present embodiment in which glass films 201 and 202 are applied as base materials and near-infrared blocking films 203 and 204 and bonding layers 205 and 206 are formed on one surface thereof, a transparent substrate 200 on both surfaces of which bonding layers 207 and 208 are formed, and a near-infrared blocking film laminate 200A according to the present embodiment in which the respective glass films with near-infrared blocking films 201A and 202A are bonded to both surfaces of the transparent substrate 200 via the bonding layers 205, 206, 207, and 208.

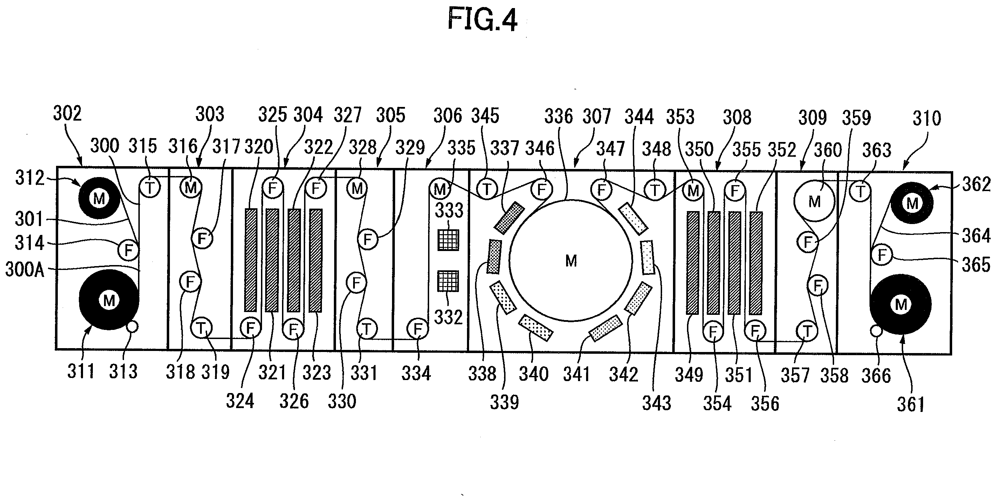

FIG. 4 is a configuration explanatory diagram of a roll-to-roll sputtering apparatus in which a glass film is continuously conveyed by a roll-to-roll method to manufacture a glass film with a near-infrared blocking film, and the manufactured glass film with a near-infrared blocking film is wound into a roll shape.

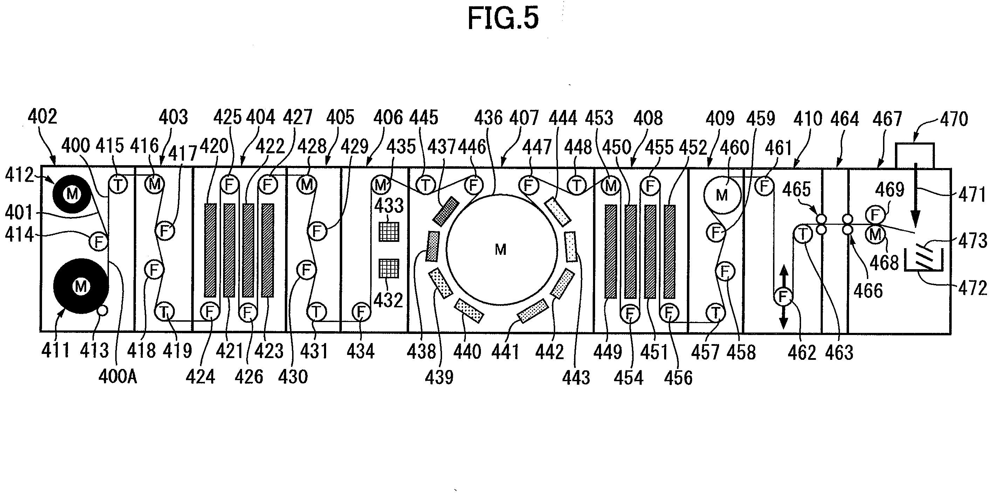

FIG. 5 is a configuration explanatory diagram of a roll-to-roll sputtering apparatus in which a glass film is continuously conveyed by a roll-to-roll method to manufacture a glass film with a near-infrared blocking film, and the manufactured glass film with a near-infrared blocking film is cut into a sheet shape.

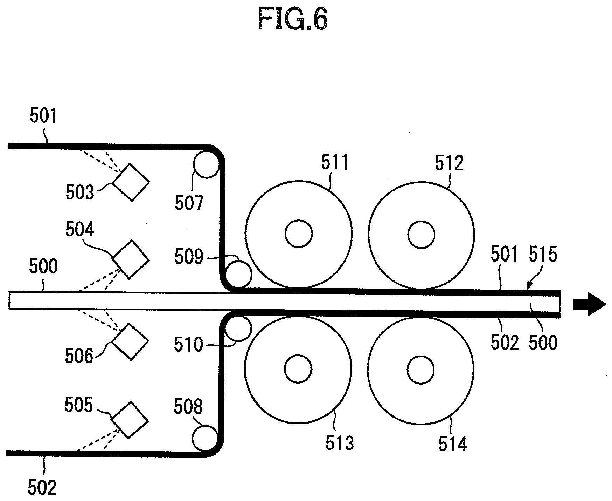

FIG. 6 is a process explanatory diagram showing a process in which long glass films with near-infrared blocking films 501 and 502 are continuously bonded to both surfaces of a transparent substrate 500 to manufacture a near-infrared blocking film laminate 515 according to the present embodiment.

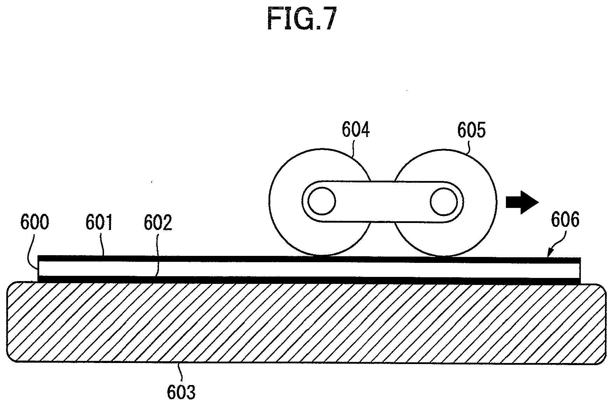

FIG. 7 is a process explanatory diagram showing a process in which cut glass films with near-infrared blocking films 601 and 602 are bonded to both surfaces of a transparent substrate 600 to manufacture a near-infrared blocking film laminate 606 according to the present embodiment.

### BEST MODES FOR PRACTICING THE INVENTION

Hereinafter, embodiments of the present invention will be specifically described.

### 1. Glass Film with Near-Infrared Blocking Film

The glass film with a near-infrared blocking film according to the present invention is
a glass film with a near-infrared blocking film, composed of:
a glass film having a thickness of 200 µm or less; and
a near-infrared blocking film formed on at least one side of the glass film and made of a composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) and having a hexagonal crystal structure,
characterized in that the maximum value of transmittance in a visible light region of a wavelength of 380 nm or more and 780 nm or less of the near-infrared blocking film is 5% or more, and reflectance at a wavelength of 1400 nm of the near-infrared blocking film is 30% or more.

Hereinafter, "(1) Near-infrared blocking film," "(2) Glass film," and "(3) Bonding layer" constituting the glass film with a near-infrared blocking film according to the present invention will be specifically described.

### (1) Near-infrared blocking film

It is necessary that the near-infrared blocking film be made of composite tungsten oxide to be a film having high transparency in the visible wavelength region and reflectivity in the near-infrared wavelength region.

The basic optical characteristics possessed by the near-infrared blocking film made of the composite tungsten oxide film represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) originate from the atomic arrangement of tungsten W and oxygen O.

Specifically, when the composite tungsten oxide constituting the near-infrared blocking film has a hexagonal crystal structure, the transmission of the near-infrared blocking film in the visible light region improves, and the blocking of the near-infrared region exceeding a wavelength of 780 nm (wavelength 780 nm to 2000 nm according to "Infrared Heating Terms" edited by Japan Electro-Heat Association, see JIS Z 8117 2002) improves. When the composite tungsten oxide has a uniform hexagonal crystal structure, the addition amount of element M is preferably 0.2 or more and 0.5 or less, more preferably 0.33, relative to tungsten 1. It is considered that by the composite tungsten oxide becoming M_{0.33}WO₃, the element M is arranged in all of the hexagonal voids. From the viewpoint of taking a hexagonal crystal structure, the element M of the composite tungsten oxide is one or more elements selected from K, Rb, Cs, Na, Sr, Ba, and Ti, desirably selected from Rb and Cs, and more desirably Cs is selected.

Further, the maximum value of transmittance in the visible light region of a wavelength of 380 nm or more and 780 nm or less of the near-infrared blocking film is 5% or more, and the reflectance at a wavelength of 1400 nm of the near-infrared blocking film is 30% or more. The near-infrared blocking film made of the composite tungsten oxide according to the present embodiment has a reflectance peak in the range of wavelength 1400 nm to 2700 nm, and if the reflectance at a wavelength of 1400 nm is 30% or more, it is possible to reduce the incidence of near-infrared rays that contribute to room temperature rise among sunlight entering from a window. In addition, the near-infrared blocking film made of the composite tungsten oxide according to the present embodiment has a transmittance peak in a wavelength range of 400 nm to 700 nm in the visible light region; if a glass film with a near-infrared blocking film having a maximum transmittance value in the visible light region of 5% or more is used for a window, even if it is difficult to peek into the room from the outside, it is possible to visually recognize the outside from the room.

Incidentally, for the near-infrared blocking film made of composite tungsten oxide to exhibit the above-mentioned optical characteristics (that is, the maximum value of transmittance in the visible light region of wavelength 380 nm or more and 780 nm or less is 5% or more, and the reflectance at a wavelength of 1400 nm is 30% or more), the crystallinity of the composite tungsten oxide becomes important. For the composite tungsten oxide to have crystallinity, it is necessary to form a film at a temperature of 400°C or higher, or to heat-treat (anneal) a non-heat-treated film formed at a temperature lower than 400°C at a temperature of 400°C or higher. Naturally, film formation at a temperature of 400°C or higher and heat treatment at a temperature of 400°C or higher may be used in combination.

Furthermore, in the present invention, the near-infrared blocking film utilizes reflection (reflectance at a wavelength of 1400 nm is 30% or more). In the case of transmitting light in the visible region and blocking light in the near-infrared region, the near-infrared blocking film can block light in the near-infrared region by absorbing or reflecting light in the near-infrared region. However, when light in the near-infrared region is absorbed, the absorbed light in the near-infrared region is converted into heat, which heats the near-infrared blocking film and the glass film serving as the film-forming base material, causing the glass film with the near-infrared blocking film to expand thermally. In the near-infrared blocking film laminate described later, if the thermal expansion coefficient of the glass film with the near-infrared blocking film and that of the transparent substrate that transmits visible light to be laminated are not close values, the glass film with the near-infrared blocking film expanded by near-infrared absorption may break. On the other hand, if the near-infrared blocking film reflects near-infrared rays, the glass film with the near-infrared blocking film is heated to a lesser extent by near-infrared rays, and expansion due to heat is also small; thus, breakage due to irradiation of near-infrared rays does not occur.

The surface resistance value of the near-infrared blocking film according to the present embodiment is desirably 10⁵ Ω/□ or more, and more desirably 10⁶ Ω/□ or more. Further, the film thickness of the near-infrared blocking film is desirably 10 nm or more and 500 nm or less, and more desirably 10 nm or more and 300 nm or less.

Incidentally, when forming the near-infrared blocking film laminate described later, if a resin film is applied as the transparent substrate that transmits visible light, the film thickness of the near-infrared blocking film can be set to 10 nm or more and 250 nm or less. By thinning the film thickness of the near-infrared blocking film, the crystallinity of the near-infrared blocking film can be improved to further improve the reflection characteristics in the near-infrared region.

### (2) Glass film

The thickness of the glass film used for the glass film with a near-infrared blocking film according to the present invention is desirably 10 µm or more and 200 µm or less, and more desirably 10 µm or more and 100 µm or less. If the thickness of the glass film is less than 10 µm, handling becomes difficult, and if the thickness exceeds 200 µm, difficulty may occur in winding or the like.

The material of the glass film is not particularly limited, and for example, silicate glass, silica glass, borosilicate glass, soda-lime glass, aluminosilicate glass, chemically strengthened glass, alkali-free glass, or the like can be used.

In the method for manufacturing a glass film with a near-infrared blocking film according to the present invention described later, a heat treatment step is performed after the film forming step of the composite tungsten oxide. The heat treatment temperature in the heat treatment step is desirably equal to or lower than the strain point, taking into consideration deformation of the glass film and the like. The strain point of the glass film is desirably 550°C or higher. As the glass film on which the composite tungsten oxide is formed, the above-mentioned silicate glass, silica glass, borosilicate glass, soda-lime glass, aluminosilicate glass, chemically strengthened glass, and alkali-free glass can be used so that a higher treatment temperature is possible in the heat treatment step.

Further, the glass film can be obtained by forming by a conventionally known float method, roll-out method, slot down-draw method, overflow down-draw method, re-draw method, or the like. Among them, it is desirable to be formed by the overflow down-draw method. The glass film formed by the overflow down-draw method can be formed with a thickness of the glass film in the range of 10 µm or more and 200 µm or less, and can maintain surface smoothness.

Further, when plate glass is used for the transparent substrate of the near-infrared blocking film laminate described later, it is necessary that the difference between the thermal expansion coefficient of the glass film and that of the plate glass is within 10% relative to the smaller of the two thermal expansion coefficients. In the near-infrared blocking film laminate, if the difference between the thermal expansion coefficient of the glass film and that of the plate glass exceeds 10%, the glass film may break. The near-infrared blocking film of the glass film with a near-infrared blocking film according to the present invention has a reflectance at a wavelength of 1400 nm of 30% or more, and is characterized by blocking near-infrared rays by reflection. As a result, the expansion of the glass film is slight even when irradiated with near-infrared rays. On the other hand, when blocking of near-infrared rays is performed by absorption of near-infrared rays, the glass film breaks even if the difference in thermal expansion coefficient between the glass film and the plate glass is managed within 5%.

### (3) Bonding layer

A bonding layer can be provided on the surface of the near-infrared blocking film of the glass film with a near-infrared blocking film according to the present invention. When laminating the glass film with a near-infrared blocking film and a transparent substrate transmitting visible light to form a near-infrared blocking film laminate, the bonding layer is arranged between the near-infrared blocking film and the transparent substrate to bond the two. If room temperature pressure bonding is performed after cleaning the surface of the bonding layer with an ion beam or the like, the glass film with a near-infrared blocking film and the transparent substrate transmitting visible light can be bonded.

It is desirable that the bonding layer be composed of an oxide selected from SiO₂, Al₂O₃, TiO₂, ZrO₂, and HfO₂. Room temperature bonding becomes possible by performing ion beam irradiation, plasma irradiation, atmospheric pressure plasma irradiation, or corona discharge on the surface of the bonding layer composed of these oxides to clean and activate the surface.

Furthermore, the film thickness of the bonding layer is desirably 1 nm or more and 10 nm or less, and more desirably 3 nm or more and 10 nm or less. If the film thickness of the bonding layer is less than 1 nm, the effect of bonding cannot be expected. On the other hand, if the film thickness of the bonding layer exceeds 10 nm, it may affect the heat treatment of the composite tungsten oxide described above and inhibit the crystallization of the composite tungsten oxide.

The bonding layer can be formed by sputtering deposition. A sputtering target using a metal or metal oxide as a raw material for forming the bonding layer can be used. When it is desired to form an Al₂O₃ film, a metal Al target or a metal oxide Al₂O₃ target may be used; when it is desired to form a TiO₂ film, a metal Ti target or a metal oxide TiO₂ target may be used; when it is desired to form a ZrO₂ film, a metal Zr target or a metal oxide ZrO₂ target may be used; and when it is desired to form an HfO₂ film, a metal Hf target or a metal oxide HfO₂ target may be used. Even with a metal target, an insulating metal oxide can be obtained by reactive sputtering in which oxygen is introduced.

### 2. Method for Manufacturing Glass Film with Near-Infrared Blocking Film

### (1) Film forming step

The near-infrared blocking film of the glass film with a near-infrared blocking film according to the present invention blocks near-infrared rays by utilizing reflection of near-infrared rays (reflectance at a wavelength of 1400 nm is 30% or more).

In order to obtain a near-infrared blocking film made of composite tungsten oxide that reflects near-infrared rays, it is desirable to form a film on a glass film as a base material by a magnetron sputtering method, an ion beam sputtering method, a pulsed laser deposition method, or an electron beam vapor deposition method. In these film forming methods, the composite tungsten oxide is formed as a continuous film.

In addition, if possible, heating to a temperature of 400°C or higher during film formation is also beneficial for improving the crystallinity of the composite tungsten oxide.

### (1-1) Film formation method by sputtering method

The target used when forming a film of composite tungsten oxide (non-heat-treated film if crystallization by heat treatment has not been done) is not particularly limited, but for example, a cesium composite tungsten oxide sintered body target can be used.

The composition of the target used when forming the composite tungsten oxide (non-heat-treated film) preferably has a ratio Cs/W, which is the ratio of the amount of substance of cesium (Cs) to tungsten (W) contained in the target, of 0.2 or more and 0.7 or less. This is because the composition of the target used during film formation is reflected in Cs/W, which is the ratio of the amount of substance of cesium (Cs) to tungsten (W) contained in the formed film.

The crystal structure of the target is not particularly limited because it does not directly affect the crystal structure of the film to be formed. Further, the target preferably has a relative density of 70% or more and a specific resistance of 1 Ω·cm or less.

The method for manufacturing the target is not particularly limited, but for example, it can be manufactured by hot press sintering cesium composite tungsten oxide powder in a vacuum or an inert atmosphere. This is because the sintered body manufactured in this way has strength to withstand machining in target manufacturing and brazing temperature during bonding, and has conductivity capable of direct current sputtering.

As the method for forming the composite tungsten oxide (non-heat-treated film), the sputtering method described above can be used. When the sputtering method is used as the film forming method, a direct current sputtering film forming method in which a direct current voltage or a pulse voltage is applied to the target is preferable. This is because the film formation rate is high and productivity is excellent.

When forming the composite tungsten oxide (non-heat-treated film), the sputtering gas is not particularly limited, but for example, argon gas or a mixed gas of argon and oxygen can be used.

Whether to use argon gas or a mixed gas in the film forming step can be selected according to the conditions of the "heat treatment step" which is the next step.

When a mixed gas is used for the sputtering gas in the film forming step, the oxygen concentration is not particularly limited; however, since the film formation rate decreases and productivity decreases if the oxygen concentration in the mixed gas is high, the oxygen concentration in the mixed gas is preferably less than 20 vol%, and more preferably 5 vol% or more and 10 vol% or less.

When argon gas is used for the sputtering gas in the film forming step, it is preferable that the argon gas purity is 99 vol% or more and the oxygen concentration is less than 1 vol%.

Then, as specific conditions for the film forming step, the ultimate vacuum before target pre-sputtering and reactive gas introduction is preferably less than 1×10⁻⁴ Pa, and more preferably less than 1×10⁻⁵ Pa.

### (1-2) Film formation method by pulsed laser deposition method

In the pulsed laser deposition method (PLD method), a raw material target installed in a vacuum chamber is irradiated with laser light from outside the vacuum chamber. By this operation, atoms or molecules are peeled off (ablated) from the target, and a thin film is formed on a base material facing the target. The pulsed laser deposition method is effective for target materials with large absorption of irradiation laser.

The pulsed laser deposition method can also be used with a tablet target having a diameter of about 20 mm. For this reason, the pulsed laser deposition method can be suitably used.

Also, the pulsed laser deposition method does not require a plasma gas such as argon required for sputtering. Furthermore, since it is said that the target composition can be transferred to the film on the base material, a film of the desired composition can be easily formed.

In the pulsed laser deposition method, it is not necessary to cool the target because the duty ratio of the laser irradiated to the target is small. Therefore, a backing plate equipped on a target used in sputtering is not required.

Oxygen, nitrogen, carbon, and the like contained in the target may be exhausted during film formation, and can also be adjusted by a reactive gas introduced during film formation.

Then, as specific conditions for the film forming step, the ultimate vacuum before reactive gas introduction is preferably less than 1×10⁻⁴ Pa, and more preferably less than 1×10⁻⁵ Pa.

### (1-3) Film formation method by electron beam vapor deposition method

The electron beam vapor deposition method is a vapor deposition method in which a target desired to be deposited is irradiated with an electron beam under a reduced pressure of 1×10⁻² Pa or less to heat and evaporate the target, thereby forming a film on a base material. As the target, a target similar to that of the sputtering method can be used.

### (2) Heat treatment step

Heat treatment is performed on the composite tungsten oxide (non-heat-treated film) represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) formed on the surface of the glass film by a film forming unit such as sputtering to form a hexagonal crystal structure. The heat treatment is performed by selecting an atmosphere according to the gas at the time of film formation such as sputtering so that the oxygen concentration of the near-infrared blocking film made of the composite tungsten oxide after the heat treatment falls within an appropriate range.

When sputtering is applied as the film forming unit, if the film is formed using a mixed gas of argon and oxygen as the gas, the heat treatment of the composite tungsten oxide (non-heat-treated film) in the heat treatment step is performed in an inert or reducing atmosphere at a temperature of 400°C to 900°C, desirably at a temperature of 400°C to 700°C, and more desirably at a temperature of 400°C to 650°C. As the inert or reducing atmosphere, nitrogen gas, argon gas, a mixed gas of hydrogen and nitrogen, a mixed gas of hydrogen and argon, or the like can be used. When film formation is performed in an atmosphere containing oxygen, if the heat treatment step is performed in an oxidizing atmosphere such as air or oxygen, oxidation of the film proceeds excessively, oxygen vacancies decrease, the crystal structure changes, and heat ray shielding performance may become low. When the heat treatment temperature is less than 400°C, the composite tungsten oxide (non-heat-treated film) remains amorphous and does not crystallize, or even if it crystallizes, the diffraction peak of the hexagonal crystal in X-ray diffraction is extremely weak, and the heat ray shielding performance is low. In addition, the hexagonal crystal structure maintains the structure even at a high temperature of 900°C or higher in an inert or reducing atmosphere; however, if the heat treatment temperature is higher than 1000°C, alteration of the film due to reaction between the composite tungsten oxide (non-heat-treated film) and the glass film or disappearance of the film due to peeling occurs. Considering these matters, it is necessary to appropriately adjust the heat treatment conditions so that the reflectance at a wavelength of 1400 nm becomes 30% or more.

In addition, the heat treatment needs to be carried out at a temperature determined in consideration of the strain point and glass transition point of the glass film; in particular, if heat treatment is performed at a temperature higher than the glass transition point, deformation of the glass film may also occur. Here, the "strain point" is a temperature corresponding to a viscosity of the heated glass of about 10¹³ dPa·s, and the "strain point" is a temperature lower than the glass transition point. Therefore, it is desirable to perform the heat treatment at a temperature equal to or lower than the "strain point."

### 3. Near-Infrared Blocking Film Laminate

The near-infrared blocking film laminate according to the present invention is composed of a transparent substrate that transmits visible light, and the above-mentioned glass film with a near-infrared blocking film, which is laminated on the transparent substrate.

### (1) Near-infrared blocking film laminate according to a conventional example

The near-infrared blocking film laminate shown in FIG. 1 can be manufactured by applying plate glass 10 as a base material and forming near-infrared blocking films 11 and 12 made of composite tungsten oxide on both surfaces of the plate glass 10 by a film forming unit such as sputtering. However, when the plate glass 10 is used as the base material, since it is difficult to wind the plate glass 10 into a roll shape and continuously convey it by a roll-to-roll method as described above, the near-infrared blocking film laminate shown in FIG. 1 cannot be manufactured efficiently.

In addition, since the near-infrared blocking film made of composite tungsten oxide requires heat treatment of the composite tungsten oxide (non-heat-treated film) at a temperature of 400°C or higher to crystallize the composite tungsten oxide, a resin film cannot be used as a base material.

### (2) Near-infrared blocking film laminate according to the present invention

In the present invention, a glass film capable of heat treatment at 400°C or higher is used as a base material instead of plate glass, and the glass film is continuously conveyed by a roll-to-roll method; concurrently, a composite tungsten oxide film is formed on the glass film by unit such as sputtering with heating, or annealed after non-heating film formation, thereby efficiently obtaining the above-mentioned glass film with a near-infrared blocking film.

As described above, the near-infrared blocking film laminate according to the present invention is composed of a transparent substrate that transmits visible light, and a glass film with a near-infrared blocking film, which is laminated on the transparent substrate.

Here, as a constituent material of the transparent substrate transmitting visible light, an inorganic material selected from plate glass, transparent ceramics, or the like, or an organic material selected from a transparent resin film or a resin plate such as polyethylene terephthalate (PET), polycarbonate, acrylic resin, polystyrene resin, or the like can be utilized.

In the near-infrared blocking film laminate according to the present embodiment, it is desirable that at least one bonding surface of the glass film with a near-infrared blocking film and the transparent substrate transmitting visible light be surface-activated and then closely adhered and bonded.

To surface-activate the bonding surface in this way, at least one surface of the glass film with a near-infrared blocking film and the transparent substrate may be cleaned by plasma irradiation, ion beam irradiation, or the like. It is also beneficial to introduce hydroxyl groups onto the bonding surface by water adsorbed on the bonding surface by plasma irradiation. It is also beneficial to provide the above-mentioned bonding layer on the near-infrared blocking film surface of the glass film with a near-infrared blocking film.

Examples of the adhesion method when bonding the glass film with a near-infrared blocking film and the transparent substrate include adhesion by pressurization, or a method of pressure bonding by applying heat in addition to pressurization.

Incidentally, when a method of bonding the glass film with a near-infrared blocking film and the transparent substrate via a generally known highly transparent adhesive or double-sided tape for optical applications is adopted, the reliability of bonding in the adhesive or double-sided tape is low, and there is a risk that the glass film with a near-infrared blocking film peels off from the transparent substrate during long-term use. Therefore, in the present invention, the above-mentioned adhesion method is adopted.

### (2-1) Near-infrared blocking film laminate having no bonding layer

FIG. 2 is each configuration explanatory diagram of glass films with near-infrared blocking films 101A and 102A according to the present embodiment in which glass films 101 and 102 are applied as base materials and near-infrared blocking films 103 and 104 are formed on one surface thereof, a transparent substrate 100, and a near-infrared blocking film laminate 100A according to the present embodiment in which the respective glass films with near-infrared blocking films 101A and 102A are bonded to both surfaces of the transparent substrate 100.

As shown in FIG. 2, the near-infrared blocking film laminate 100A according to the present embodiment can be obtained by bonding the glass films with near-infrared blocking films 101A and 102A according to the present embodiment, in which near-infrared blocking films 103 and 104 are formed on one surface, to the transparent substrate 100 by the adhesion method described above.

When polycarbonate is applied to the transparent substrate 100, bonding is possible if the temperature is raised to the Vicat softening temperature of 149°C or higher. Even in a method of applying a temperature equal to or higher than the Vicat softening temperature of 149°C, it is desirable to expose the active surface of the bonding surface with an argon ion beam or the like. Note that the Vicat softening temperature is the temperature at which a thermoplastic plastic begins to soften.

### (2-2) Near-infrared blocking film laminate having a bonding layer

FIG. 3 is each configuration explanatory diagram of glass films with near-infrared blocking films 201A and 202A according to the present embodiment in which glass films 201 and 202 are applied as base materials and near-infrared blocking films 203 and 204 and bonding layers 205 and 206 are formed on one surface thereof, a transparent substrate 200 on both surfaces of which bonding layers 207 and 208 are formed, and a near-infrared blocking film laminate 200A according to the present embodiment in which the respective glass films with near-infrared blocking films 201A and 202A are bonded to both surfaces of the transparent substrate 200 via the bonding layers 205, 206, 207, and 208.

As shown in FIG. 3, the near-infrared blocking film laminate 200A according to the present embodiment can be obtained by bonding the glass films with near-infrared blocking films 201A and 202A according to the present embodiment, in which near-infrared blocking films 203 and 204 and bonding layers 205 and 206 are formed on one surface, to the transparent substrate 200 on both surfaces of which bonding layers 207 and 208 are formed, by the adhesion method described above.

It is desirable to expose the active surface of each bonding surface by an argon ion beam or the like; if the bonding layers 205, 206, 207, and 208 having a thickness of about 1 to 10 nm are insulators such as Al₂O₃, TiO₂, ZrO₂, HfO₂, etc., room temperature pressure bonding is possible. However, slight heating and pressurization are preferable to obtain stable bonding strength. Since the glass films with near-infrared blocking films 201A and 202A are thin and air bubbles easily enter, it is preferable to bond them to the transparent substrate 200 made of glass or polycarbonate or the like in a vacuum.

In the near-infrared blocking film laminate 200A according to the present embodiment shown in FIG. 3, the bonding layers 205, 206, 207, and 208 having a thickness of about 1 to 10 nm are provided on the glass films with near-infrared blocking films 201A and 202A and the transparent substrate 200 (for example, composed of float glass or polycarbonate), respectively; however, similar to the near-infrared blocking film laminate 100A shown in FIG. 2, pressure heating bonding near the softening point temperature is possible without interposing the bonding layers 205, 206, 207, and 208.

### 4. Method for Manufacturing Glass Film with Near-Infrared Blocking Film Using Roll-to-Roll Sputtering Apparatus

### (1) Method for forming near-infrared blocking film

Next, a method for forming a near-infrared blocking film made of composite tungsten oxide by which near-infrared rays are reflected (reflectance at a wavelength of 1400 nm is 30% or more) will be specifically described below.

As the base material for forming the near-infrared blocking film made of composite tungsten oxide, a flexible long glass film is used instead of the conventional plate glass, and is continuously conveyed by a roll-to-roll method. Further, the film forming method of the composite tungsten oxide constituting the near-infrared blocking film is desirably sputtering film formation considering mass productivity, and as its power source, a DC power source, a medium frequency power source, a high frequency power source, a pulse power source, a high current pulse power source, or the like can be used.

The composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) forms a hexagonal crystal structure by film formation under heating conditions of 400°C or higher or heat treatment after film formation, thereby exhibiting the function of reflecting near-infrared rays.

For this reason, the roll-to-roll sputtering apparatus used for manufacturing the glass film with a near-infrared blocking film is equipped with at least one of a "film forming process zone" for forming a film of composite tungsten oxide under heating at a temperature of 400°C or higher or an "annealing zone" for performing heat treatment at a temperature of 400°C or higher on the post-deposition film (non-heat-treated film), and may be equipped with both the "film forming process zone" for forming a film of composite tungsten oxide under heating at a temperature of 400°C or higher and the "annealing zone."

In addition, the roll-to-roll sputtering apparatus used for manufacturing the glass film with a near-infrared blocking film requires a "heater zone" for drying moisture on the glass film surface before film formation and the above-mentioned "film forming process zone" for forming the composite tungsten oxide film.

Furthermore, if the temperature in the "film forming process zone" is less than 400°C, the above-mentioned "annealing zone" for heat-treating (heat treatment step) the composite tungsten oxide film (non-heat-treated film) is required.

Hereinafter, the process of forming a film of composite tungsten oxide represented by the general formula MxWyOz on a long glass film using the roll-to-roll sputtering apparatus shown in FIG. 4 and FIG. 5 will be described.

In FIGS. 4 and 5, the exhaust system pump and the reaction gas introduction mechanism are not shown. Further, to exhaust moisture desorbed from the inner wall of the chamber, installation of a cryocoil or cryopanel that condenses moisture at a low temperature is effective.

### (2) Roll-to-roll sputtering apparatus in which glass film with near-infrared blocking film is wound into a roll shape

As shown in FIG. 4, the roll-to-roll sputtering apparatus in which the manufactured glass film with a near-infrared blocking film is wound into a roll shape comprises an unwinding zone 302, a conveyance zone 303, a heater zone 304, a conveyance zone 305, a surface treatment zone 306, a film forming process zone 307, an annealing zone 308, a conveyance cooling zone 309, and a winding zone 310.

It is possible to adjust the pressure by installing opposing slit rolls between each zone and introducing argon gas or the like into each zone. The unwinding zone 302 corresponds to the "glass film unwinding step" of the method for manufacturing a glass film with a near-infrared blocking film according to the present invention.

Here, explaining the symbols described on each roll, "F" is a free roll rotated by the conveyance of the glass film without having a driving force, "T" is a tension roll equipped with a tension sensor on the shaft or inside of the free roll, and "M" is a motor-driven roll whose rotation is controlled by a motor. These roll arrangements show a necessary minimum example and are not limited to these roll arrangements. A carrier film (interleaf film) 301 is often attached to the glass film 300 to facilitate winding.

First, a glass film with carrier film 300A is set on a glass film with carrier film unwinding roll 311 in the unwinding zone 302, and the carrier film (interleaf film) 301 is wound on a carrier film winding roll 312 via a free roll 314. In order to pass the glass film 300 through the roll-to-roll sputtering apparatus, a method of connecting the glass film 300 to a threading film previously passed through the conveyance route and pulling it is often used.

After setting the glass film with carrier film 300A, vacuum evacuation is started. Generally, after roughing with a dry pump, evacuation to high vacuum is performed by a plurality of turbo molecular pumps. It is effective to also use a cryopipe to exhaust moisture.

The glass film with carrier film 300A passes through a touch roll 313 for preventing the glass film 300A unwound from the glass film with carrier film unwinding roll 311 from flapping, and then the carrier film (interleaf film) 301 is peeled from the glass film with carrier film 300A ahead of the free roll 314; thereafter, the carrier film 301 is wound on the carrier film winding roll 312 as described above. The glass film 300 from which the carrier film (interleaf film) 301 has been peeled enters the conveyance zone 303 via a tension roll 315 for measuring unwinding tension. The unwinding tension is detected by the tension roll 315, and the unwinding tension is adjusted by the balance between a motor-driven roll 316 and the glass film with carrier film unwinding roll 311.

The glass film 300 carried into the conveyance zone 303 is carried into the heater zone 304 via the motor-driven roll 316, free rolls 317, 318, and a tension roll 319. Here, the conveyance tension is detected by the tension roll 319, and the conveyance tension of the heater zone 304 is adjusted by a motor-driven roll 328.

The glass film 300 carried into the heater zone 304 passes between heaters 320, 321, 322, 323 by free rolls 324, 325, 326, 327 and enters the conveyance zone 305. The heater needs to irradiate a wavelength absorbed by the glass film; for example, a carbon heater, a medium-infrared heater, a SiC heater, or the like can be adopted. The temperature of the heater can be maintained at a set temperature by PID-controlling the current value with a thermometer such as a thermocouple.

The glass film 300 carried into the conveyance zone 305 is carried into the surface treatment zone 306 via the motor-driven roll 328, free rolls 329, 330, and a tension roll 331. Here, the conveyance tension is detected by the tension roll 331, and the conveyance tension of the surface treatment zone 306 is adjusted by a motor-driven roll 335.

The glass film 300 carried into the surface treatment zone 306 passes in front of surface treatment devices 332, 333 via a free roll 334 and the motor-driven roll 335, and enters the film forming process zone 307. An ion beam, plasma, or the like can be used for the surface treatment device.

The glass film 300 carried into the film forming process zone 307 enters the annealing zone 308 via a tension roll 345, a free roll 346, a process roll 336, a free roll 347, and a tension roll 348. The tension at which the glass film 300 enters the process roll 336 is detected by the tension roll 345 and adjusted by the rotational speed balance between the motor-driven roll 335 and the process roll 336, while the tension at which the glass film 300 exits the process roll 336 is detected by the tension roll 348 and adjusted by the rotational speed balance between a motor-driven roll 353 and the process roll 336.

Around the process roll 336, sputtering cathodes 337, 338, 339, 340, 341, 342, 343, 344 are arranged. This sputtering cathode group may be of a flat plate type or a cylindrical type. A sputtering gas (argon) and a gas (oxygen) necessary for reactive sputtering are guided to each sputtering cathode via a flow meter. The process roll 336 and the sputtering cathodes constitute the film forming process zone 307.

The glass film 300 carried into the annealing zone 308 passes between heaters 349, 350, 351, 352 by the motor-driven roll 353, free rolls 354, 355, 356 and enters the conveyance cooling zone 309. The heaters 349, 350, 351, 352 constitute the annealing zone. At least the heater 349 needs to irradiate a wavelength absorbed by the glass film; for example, a carbon heater, a medium-infrared heater, a SiC heater, or the like, which is an infrared heater emitting infrared rays having a wavelength of 1500 nm or more, can be adopted. Once crystallization of the composite tungsten oxide begins, absorption of near-infrared rays by the composite tungsten oxide begins, crystallization is promoted to become a reflective film, and a near-infrared heater with high energy density can be used in the process of absorbing near-infrared rays. Specifically, halogen heaters can be arranged for the heaters 351 and 352. The temperature of the heater can be maintained at a set temperature by PID-controlling the current value with a thermometer such as a thermocouple. Also, a gas required during annealing may be introduced.

Incidentally, when performing annealing treatment in-line after film formation of composite tungsten oxide in the roll-to-roll sputtering apparatus, since the conveyance speed of the glass film is also related to the residence time in the annealing zone 308, it is necessary to set the conveyance speed so that the residence time is sufficient for the composite tungsten oxide to crystallize. Naturally, after forming a film of composite tungsten oxide on the glass film with the roll-to-roll sputtering apparatus, annealing treatment may be separately performed by another vacuum annealing apparatus or a nitrogen/argon/reducing atmosphere annealing apparatus.

Here, the conveyance tension is detected by a tension roll 357, and the conveyance tension of the conveyance cooling zone 309 is adjusted by a motor-driven cooling roll 360.

The glass film 300 carried into the conveyance cooling zone 309 enters the winding zone 310 via the tension roll 357, free rolls 358, 359, and the motor-driven cooling roll 360. Cooling the glass film after film formation and annealing by the motor-driven cooling roll 360 is to prevent winding tightening when cooled after winding, and the number of motor-driven cooling rolls 360 may be increased to gradually cool the glass film as necessary.

The glass film 300 carried into the winding zone 310 passes through a tension roll 363, has a carrier film 364 unwound from a carrier film unwinding roll 362 attached on a free roll 365, passes through a touch roll 366 for preventing the film from flapping when wound, and is wound on a winding roll 361. The winding tension is detected by the tension roll 363, and the winding tension is adjusted by the balance between the motor-driven cooling roll 360 and the winding roll 361.

### (3) Roll-to-roll sputtering apparatus in which glass film with near-infrared blocking film is cut into sheet shape

As shown in FIG. 5, the roll-to-roll sputtering apparatus in which the manufactured glass film with a near-infrared blocking film is cut into a sheet shape comprises an unwinding zone 402, a conveyance zone 403, a heater zone 404, a conveyance zone 405, a surface treatment zone 406, a film forming process zone 407, an annealing zone 408, a conveyance cooling zone 409, a tension adjustment zone 410, a differential exhaust zone 464, and a cutting zone 467.

It is possible to adjust the pressure by installing opposing slit rolls between each zone and introducing argon gas or the like into each zone. Explaining the symbols described on each roll, "F" is a free roll rotated by the conveyance of the glass film without having a driving force, "T" is a tension roll equipped with a tension sensor on the shaft or inside of the free roll, and "M" is a motor-driven roll whose rotation is controlled by a motor. These roll arrangements show a necessary minimum example and are not limited to these roll arrangements. A carrier film (interleaf film) 401 is often attached to the glass film 400 to facilitate winding.

First, a glass film with carrier film 400A is set on a glass film with carrier film unwinding roll 411 in the unwinding zone 402, and the carrier film (interleaf film) 401 is wound on a carrier film winding roll 412 via a free roll 414. In order to pass the glass film 400 through the roll-to-roll sputtering apparatus, a method of connecting the glass film 400 to a threading film previously passed through the conveyance route and pulling it is often used.

After setting the glass film with carrier film 400A, vacuum evacuation is started. Generally, after roughing with a dry pump, evacuation to high vacuum is performed by a plurality of turbo molecular pumps. It is effective to also use a cryopipe to exhaust moisture.

The glass film with carrier film 400A passes through a touch roll 413 for preventing the glass film 400A unwound from the glass film with carrier film unwinding roll 411 from flapping, and then the carrier film (interleaf film) 401 is peeled from the glass film with carrier film 400A ahead of the free roll 414; thereafter, the carrier film 401 is wound on the carrier film winding roll 412 as described above. The glass film 400 from which the carrier film (interleaf film) 401 has been peeled enters the conveyance zone 403 via a tension roll 415 for measuring unwinding tension. The unwinding tension is detected by the tension roll 415, and the unwinding tension is adjusted by the balance between a motor-driven roll 416 and the glass film with carrier film unwinding roll 411.

The glass film 400 carried into the conveyance zone 403 is carried into the heater zone 404 via the motor-driven roll 416, free rolls 417, 418, and a tension roll 419. Here, the conveyance tension is detected by the tension roll 419, and the conveyance tension of the heater zone 404 is adjusted by a motor-driven roll 428.

The glass film 400 carried into the heater zone 404 passes between heaters 420, 421, 422, 423 by free rolls 424, 425, 426, 427 and enters the conveyance zone 405. The heater needs to irradiate a wavelength absorbed by the glass film; for example, a carbon heater, a medium-infrared heater, a SiC heater, or the like can be adopted. The temperature of the heater can be maintained at a set temperature by PID-controlling the current value with a thermometer such as a thermocouple.

The glass film 400 carried into the conveyance zone 405 is carried into the surface treatment zone 406 via the motor-driven roll 428, free rolls 429, 430, and a tension roll 431. Here, the conveyance tension is detected by the tension roll 431, and the conveyance tension of the surface treatment zone 406 is adjusted by a motor-driven roll 435.

The glass film 400 carried into the surface treatment zone 406 passes in front of surface treatment devices 432, 433 via a free roll 434 and the motor-driven roll 435, and enters the film forming process zone 407. An ion beam, plasma, or the like can be used for the surface treatment device.

The glass film 400 carried into the film forming process zone 407 enters the annealing zone 408 via a tension roll 445, a free roll 446, a process roll 436, a free roll 447, and a tension roll 448. The tension at which the glass film 400 enters the process roll 436 is detected by the tension roll 445 and adjusted by the rotational speed balance between the motor-driven roll 435 and the process roll 436, while the tension at which the glass film 400 exits the process roll 436 is detected by the tension roll 448 and adjusted by the rotational speed balance between a motor-driven roll 453 and the process roll 436.

Around the process roll 436, sputtering cathodes 437, 438, 439, 440, 441, 442, 443, 444 are arranged. This sputtering cathode group may be of a flat plate type or a cylindrical type. A sputtering gas (argon) and a gas (oxygen) necessary for reactive sputtering are guided to each sputtering cathode via a flow meter. The process roll 436 and the sputtering cathodes constitute the film forming process zone 407.

The glass film 400 carried into the annealing zone 408 passes between heaters 449, 450, 451, 452 by the motor-driven roll 453, free rolls 454, 455, 456 and enters the conveyance cooling zone 409. The heaters 449, 450, 451, 452 constitute the annealing zone. At least the heater 449 needs to irradiate a wavelength absorbed by the glass film; for example, a carbon heater, a medium-infrared heater, a SiC heater, or the like, which is an infrared heater emitting infrared rays having a wavelength of 1500 nm or more, can be adopted. Once crystallization of the composite tungsten oxide begins, absorption of near-infrared rays by the composite tungsten oxide begins, crystallization is promoted to become a reflective film, and a near-infrared heater with high energy density can be used in the process of absorbing near-infrared rays. Specifically, halogen heaters can be arranged for the heaters 451 and 452. The temperature of the heater can be maintained at a set temperature by PID-controlling the current value with a thermometer such as a thermocouple. Also, a gas required during annealing may be introduced.

Incidentally, when performing annealing treatment in-line after film formation of composite tungsten oxide in the roll-to-roll sputtering apparatus, since the conveyance speed of the glass film is also related to the residence time in the annealing zone 408, it is necessary to set the conveyance speed so that the residence time is sufficient for the composite tungsten oxide to crystallize. Naturally, after forming a film of composite tungsten oxide on the glass film with the roll-to-roll sputtering apparatus, annealing treatment may be separately performed by another vacuum annealing apparatus or a nitrogen/argon/reducing atmosphere annealing apparatus.

Here, the conveyance tension is detected by a tension roll 457, and the conveyance tension of the conveyance cooling zone 409 is adjusted by a motor-driven cooling roll 460.

The glass film 400 carried into the conveyance cooling zone 409 enters the tension adjustment zone 410 via the tension roll 457, free rolls 458, 459, and the motor-driven cooling roll 460. Cooling the glass film after film formation and annealing by the motor-driven cooling roll 460 is to prevent winding tightening when cooled after winding, and the number of motor-driven cooling rolls 460 may be increased to gradually cool the glass film as necessary.

The glass film 400 carried into the tension adjustment zone 410 enters the differential exhaust zone 464 via a free roll 461, a dancer roll 462, and a tension roll 463. When cutting the glass film after film formation, conveyance of the glass film is intermittently stopped; at that time, the conveyance tension is detected by the tension roll 463 and the position of the dancer roll 462 is adjusted up and down to maintain the set tension.

The glass film 400 passes through macaroni packings (hollow packings) 465, 466 located before and after the differential exhaust zone 464 and enters the cutting zone 467. By stopping film formation and conveyance and sandwiching the glass film after film formation with these macaroni packings (hollow packings) 465, 466, a device may be devised so that the glass film after film formation after cutting, that is, the glass film with a near-infrared blocking film, can be taken out without releasing the vacuum of the roll-to-roll sputtering apparatus main body to the atmosphere.

The glass film 400 is sandwiched between a motor-driven roll 468 and a nip roll 469, cut by, for example, a laser beam 471 irradiated from a laser device 470, and glass films with near-infrared blocking films 473 cut into sheet shapes are stacked in a tray 472. An interleaf film may be inserted during stacking of the glass films with near-infrared blocking films 473. Cutting may be performed by intermittently stopping the film, or the beam position may be scanned diagonally in accordance with the conveyance speed.

### 5. Method for Manufacturing Near-Infrared Blocking Film Laminate

The near-infrared blocking film laminate according to the present invention is composed of a transparent substrate that transmits visible light as described above, and the above-mentioned glass film with a near-infrared blocking film, which is laminated on the transparent substrate.

Here, the transparent substrate refers to a substrate having a visible light transmittance of 5% or more. If the visible light transmittance of the transparent substrate is 5% or more, even if it is difficult to peek into the room from the outside, it is possible to visually recognize the outside from the room.

### (1) Long glass film with near-infrared blocking film

FIG. 6 is a process explanatory diagram showing a process in which long glass films with near-infrared blocking films 501 and 502 are continuously bonded to both surfaces of a transparent substrate 500 to manufacture a near-infrared blocking film laminate 515.

That is, both surfaces of the transparent substrate 500 are activated by ion beam or plasma processing devices 504, 506 in a vacuum, and one surface of the glass films with near-infrared blocking films 501, 502 is activated by ion beam or plasma processing devices 503, 505; alternatively, both surfaces of the transparent substrate 500 are activated by atmospheric pressure plasma processing or corona processing devices 504, 506 in the atmosphere, and one surface of the glass films with near-infrared blocking films 501, 502 is activated by atmospheric pressure plasma processing or corona processing devices 503, 505 to expose the respective activated surfaces; and, the long glass films with near-infrared blocking films 501, 502 are guided by guide rolls 507, 508, 509, 510 to both surfaces of the transparent substrate 500, and the glass films with near-infrared blocking films 501, 502 are bonded to both surfaces of the transparent substrate 500 by temperature-controlled rotating hot rolls 511, 512, 513, 514; thereby, it is possible to manufacture the near-infrared blocking film laminate 515.

Although the near-infrared blocking film laminate 515 shown in FIG. 6 has a structure in which the glass films with near-infrared blocking films 501, 502 are bonded to both surfaces of the transparent substrate 500, a structure in which a glass film with a near-infrared blocking film is bonded to only one surface of the transparent substrate 500 may be adopted if optical characteristics are satisfied.

### (2) Cut glass film with near-infrared blocking film

FIG. 7 is a process explanatory diagram showing a process in which cut glass films with near-infrared blocking films 601 and 602 are bonded to both surfaces of a transparent substrate 600 to manufacture a near-infrared blocking film laminate 606.

That is, both surfaces of the transparent substrate 600 are activated by an ion beam or plasma processing device in a vacuum, and one surface of the glass films with near-infrared blocking films 601, 602 is activated by an ion beam or plasma processing device; alternatively, both surfaces of the transparent substrate 600 are activated by an atmospheric pressure plasma processing or corona processing device in the atmosphere, and one surface of the glass films with near-infrared blocking films 601, 602 is activated by an atmospheric pressure plasma processing or corona processing device to expose the respective activated surfaces; and, a structure in which the glass films with near-infrared blocking films 601, 602 are superimposed on both surfaces of the transparent substrate 600 is placed on a temperature-controlled hot plate 603, and the glass films with near-infrared blocking films 601, 602 are bonded to both surfaces of the transparent substrate 600 by temperature-controlled rotating hot rolls 604, 605 and the hot plate 603; thereby, it is possible to manufacture the near-infrared blocking film laminate 606.

Although the near-infrared blocking film laminate 606 shown in FIG. 7 also has a structure in which the glass films with near-infrared blocking films 601, 602 are bonded to both surfaces of the transparent substrate 600, a structure in which a glass film with a near-infrared blocking film is bonded to only one surface of the transparent substrate 600 may be adopted if optical characteristics are satisfied.

The near-infrared blocking film laminate composed of the transparent substrate that transmits visible light and the glass film with a near-infrared blocking film can be used as a transparent heat ray reflective member that reflects light in the near-infrared region for windows of automobiles, buildings, and the like. Examples

Hereinafter, examples of the present invention will be described in detail, but the present invention is not limited to the following examples.

### (1) Measurement Method

### (1-1) Surface Resistance

The surface resistance of the film was measured using Loresta-GX manufactured by Mitsubishi Chemical Corporation.

### (1-2) Film Thickness

The film thickness was measured with an optical profiler (NewView 6200 manufactured by Zygo Corporation).

### (1-3) Maximum Transmittance in Visible Light Region and Reflectance at Wavelength of 1400 nm

Regarding the optical properties of the obtained film, transmittance and 8° incident diffuse reflectance were measured using a spectrophotometer V-670 (manufactured by JASCO Corp.).

Then, from the measurement results, the maximum value of transmittance in the range of the visible light region (wavelength 380 nm or more and 780 nm or less) was determined.

### [Examples 1-10]

### (Target Preparation Step)

An aqueous cesium carbonate solution and tungsten trioxide hydrate were mixed and kneaded at a ratio such that the ratio of the amount of substance of cesium (Cs) and tungsten (W) was Cs/W = 0.33, and dried in the atmosphere at 100°C for 12 hours to prepare a precursor.

The precursor was heated to 800°C in a 5 vol% H₂-95 vol% N₂ gas stream and held for 1 hour, and then slowly cooled to room temperature to obtain a dark blue composite tungsten oxide powder (hereinafter referred to as CsWO powder).

This CsWO powder was charged into a hot press apparatus and sintered under conditions of a vacuum atmosphere, a temperature of 950°C, and a pressing pressure of 250 kgf/cm² to produce a CsWO sintered body.

As a result of chemical analysis of the composition of the sintered body, Cs/W, which is the ratio of the amount of substance of Cs and W, was 0.33.

This oxide sintered body was ground by machining to a diameter of 20 mm and a thickness of 4 mm to produce a CsWO target tablet.

### (Film Forming Step)

For the film forming step, the roll-to-roll sputtering apparatus shown in FIG. 4 was used.

The thickness of the glass film 300 is 50 µm, the width is 500 mm, and the length is 100 m.

Eight cathodes are arranged around the process roll 336, and from the first cathode 337 to the sixth cathode 342, targets using the above-mentioned Cs_{0.33}WO₃ powder as a raw material for forming a near-infrared blocking film were mounted.

For the seventh cathode 343 and the eighth cathode 344, metal oxide targets for forming the bonding layers described in Table 2-1 to Table 2-2 were mounted. In Examples 7 to 10, no metal oxide target was mounted. During film formation of the bonding layer, even if a metal oxide target was used, the oxygen partial pressure during film formation was pressure-controlled to 2 Pa for the purpose of compensating for insufficient oxygen.

Each target adopts a dual magnetron sputtering method using a medium frequency pulse 40 Hz power source as a set of two. By controlling the amount of inserted oxygen so that the voltage or current value of the medium frequency pulse power source of this dual magnetron sputtering method becomes constant, it was possible to obtain an oxide film at a film formation speed close to the metal mode in a transition mode intermediate between the metal mode (film formation speed is fast but oxidation is insufficient) and the oxide mode (film formation speed is slow).

Further, the process roll 336 was temperature-controlled to 200°C by a heat medium.

Through a series of operations, non-heat-treated films and bonding layers according to Examples 1 to 10 were formed.

### (Heat Treatment Step)

In this example, in order to make the glass film 300 on which the non-heat-treated film was formed stay in the 3 m annealing zone 308 for 6 minutes, the conveyance speed of the glass film 300 was set to 0.5 m/min, and the temperature in the annealing zone 308 was temperature-controlled to 600°C.

The heaters 349 and 350 of the annealing zone 308 were SiC heaters, and the heaters 351 and 352 were halogen heaters.

The glass film with a near-infrared blocking film 300 that passed through the annealing zone 308 was cooled through the motor-driven cooling roll 360 and then wound on the winding roll 361. Further, a PET film was used for the carrier film (interleaf film) 364 when winding the glass film 300 with a near-infrared blocking film on the winding roll 361.

### (Lamination Step)

### (1) Examples 1 to 6

Glass films with near-infrared blocking films made of composite tungsten oxide (Cs_{0.33}WO₃) having film thicknesses shown in Table 1-1 to Table 1-2 were bonded to float glass (plate glass) having a substrate thickness of 3 mm via bonding layers under lamination conditions (presence/absence of bonding layer, atmosphere, surface treatment, lamination temperature, lamination pressure, one side or both sides) shown in Table 2-1 to Table 2-2 to manufacture near-infrared blocking film laminates according to Examples 1 to 6.

### (2) Examples 7 to 8

Glass films with near-infrared blocking films made of composite tungsten oxide (Cs_{0.33}WO₃) having film thicknesses shown in Table 1-1 to Table 1-2 were bonded to float glass (plate glass) having a substrate thickness of 3 mm without interposing bonding layers under lamination conditions (presence/absence of bonding layer, atmosphere, surface treatment, lamination temperature, lamination pressure, one side or both sides) shown in Table 2-1 to Table 2-2 to manufacture near-infrared blocking film laminates according to Examples 7 to 8.

### (3) Examples 9 to 10

Glass films with near-infrared blocking films made of composite tungsten oxide (Cs_{0.33}WO₃) having film thicknesses shown in Table 1-1 to Table 1-2 were bonded to polycarbonate plates having a substrate thickness of 3 mm without interposing bonding layers under lamination conditions (presence/absence of bonding layer, atmosphere, surface treatment, lamination temperature, lamination pressure, one side or both sides) shown in Table 2-1 to Table 2-2 to manufacture near-infrared blocking film laminates according to Examples 9 to 10.

### (4) Optical Properties and Surface Resistance Value

The optical properties (maximum transmittance in visible wavelength region, reflectance at wavelength 1400 nm) and surface resistance values of the near-infrared blocking films and near-infrared blocking film laminates according to Examples 1 to 10 were measured.

The results are described in Table 2-1 to Table 2-2.

### (Evaluation)

It is confirmed that the near-infrared blocking film laminates according to Examples 1 to 10 have characteristics that the maximum transmittance in the visible wavelength region is 5% or more and the reflectance at a wavelength of 1400 nm is 30% or more, and that the surface resistance value of the near-infrared blocking film has characteristics of 10⁵ Ω/□ or more.

Furthermore, it is confirmed that the glass films with near-infrared blocking films of the near-infrared blocking film laminates according to Examples 1 to 10 are efficiently manufactured using the roll-to-roll sputtering apparatus shown in FIG. 4, and cost reduction of the near-infrared blocking film laminates can be achieved.

**[Table 1-1]**

| | | | Film Forming Base Material | | | 1st to 6th Cathodes | |
|---|---|---|---|---|---|---|---|
| Item | Film Forming Method | Type | Base Material Width (mm) | Base Material Length (m) | Base Material Thickness (µm) | Target | Total Film Thickness (nm) 10 nm or more 500 nm or less |
| Criteria | | | | | | | |
| Example 1 | Roll-to-roll method | Glass film | 500 | 100 | 50 | Cs_{0.33}WO₃ | 200 |
| Example 2 | Roll-to-roll method | Glass film | 500 | 100 | 50 | Cs_{0.33}WO₃ | 100 |
| Example 3 | Roll-to-roll method | Glass film | 500 | 100 | 50 | Cs_{0.33}WO₃ | 200 |
| Example 4 | Roll-to-roll method | Glass film | 500 | 100 | 50 | Cs_{0.33}WO₃ | 100 |
| Example 5 | Roll-to-roll method | Glass film | 500 | 100 | 50 | Cs_{0.33}WO₃ | 200 |
| Example 6 | Roll-to-roll method | Glass film | 500 | 100 | 50 | Cs_{0.33}WO₃ | 100 |
| Example 7 | Roll-to-roll method | Glass film | 500 | 100 | 50 | Cs_{0.33}WO₃ | 200 |
| Example 8 | Roll-to-roll method | Glass film | 500 | 100 | 50 | Cs_{0.33}WO₃ | 100 |
| Example 9 | Roll-to-roll method | Glass film | 500 | 100 | 50 | Cs_{0.33}WO₃ | 200 |
| Example 10 | Roll-to-roll method | Glass film | 500 | 100 | 50 | Cs_{0.33}WO₃ | 100 |

**[Table 1-2]**

| | Evaluation | | | 7th to 8th Cathodes | |
|---|---|---|---|---|---|
| Item | Maximum Transmittance in Visible Wavelength Region (%) | Reflectance at Wavelength 1400 nm (%) | Surface Resistance Value (Ω/□) | Target | Total Film Thickness (nm) |
| Criteria | 5% or more | 30% or more | 10⁵ Ω/□ or more | | |
| Example 1 | 60 | 40 | 10⁶ | Al₂O₃ | 5 |
| Example 2 | 70 | 30 | 10⁶ | Al₂O₃ | 5 |
| Example 3 | 60 | 40 | 10⁶ | ZrO₂ | 5 |
| Example 4 | 70 | 30 | 10⁶ | ZrO₂ | 5 |
| Example 5 | 60 | 40 | 10⁶ | TiO₂ | 5 |
| Example 6 | 70 | 30 | 10⁶ | TiO₂ | 5 |
| Example 7 | 60 | 40 | 10⁶ | None | 0 |
| Example 8 | 70 | 30 | 10⁶ | None | 0 |
| Example 9 | 60 | 40 | 10⁶ | None | 0 |
| Example 10 | 70 | 30 | 10⁶ | None | 0 |

**[Table 2-1]**

| | Lamination Substrate | | Bonding Layer | |
|---|---|---|---|---|
| Item | Type | Substrate Thickness (mm) | Film Type | Film Thickness (nm) |
| Example 1 | Float glass | 3 | Al₂O₃ | 5 |
| Example 2 | Float glass | 3 | Al₂O₃ | 5 |
| Example 3 | Float glass | 3 | ZrO₂ | 5 |
| Example 4 | Float glass | 3 | ZrO₂ | 5 |
| Example 5 | Float glass | 3 | TiO₂ | 5 |
| Example 6 | Float glass | 3 | TiO₂ | 5 |
| Example 7 | Float glass | 3 | None | 0 |
| Example 8 | Float glass | 3 | None | 0 |
| Example 9 | Polycarbonate | 3 | None | 0 |
| Example 10 | Polycarbonate | 3 | None | 0 |

**[Table 2-2]**

| | Lamination | | | | | Evaluation | |
|---|---|---|---|---|---|---|---|
| Item | Atmosphere | Surface Treatment | Lamination Temperature (°C) | Lamination Pressure (Mpa) | One Side / Both Sides | Maximum Transmittance in Visible Wavelength Region (%) | Reflectance at Wavelength 1400 nm (%) |
| Criteria | | | | | | 5% or more | 30% or more |
| Example 1 | Vacuum | Ar Ion Beam | 200 | 0.03 | One Side | 60 | 40 |
| Example 2 | Vacuum | Ar Ion Beam | 200 | 0.03 | Both Sides | 50 | 50 |
| Example 3 | Vacuum | Ar Ion Beam | 200 | 0.03 | One Side | 60 | 40 |
| Example 4 | Vacuum | Ar Ion Beam | 200 | 0.03 | Both Sides | 50 | 50 |
| Example 5 | Vacuum | Ar Ion Beam | 200 | 0.03 | One Side | 60 | 40 |
| Example 6 | Vacuum | Ar Ion Beam | 200 | 0.03 | Both Sides | 50 | 50 |
| Example 7 | Vacuum | Ar Ion Beam | 600 | 0.05 | One Side | 60 | 40 |
| Example 8 | Vacuum | Ar Ion Beam | 600 | 0.05 | Both Sides | 50 | 50 |
| Example 9 | Vacuum | Ar Ion Beam | 150 | 0.05 | One Side | 60 | 40 |
| Example 10 | Vacuum | Ar Ion Beam | 150 | 0.05 | Both Sides | 50 | 50 |

### POSSIBILITY OF INDUSTRIAL APPLICATION

According to the method of the present invention, since a glass film having a thickness of 200 µm or less is applied to a base material on which a near-infrared blocking film made of composite tungsten oxide is formed, and it becomes possible to wind the glass film into a roll shape and perform continuous conveyance by a roll-to-roll method, a composite tungsten oxide film functioning as a heat ray shielding film can be efficiently manufactured; therefore, it has industrial applicability to be used as windows of automobiles and buildings where heat ray shielding properties and radio wave transparency are required.

### EXPLANATIONS OF LETTERS AND NUMERALS

10: Plate glass
11, 12: Near-infrared blocking film
100: Transparent substrate
100A: Near-infrared blocking film laminate
101, 102: Glass film
101A, 102A: Glass film with near-infrared blocking film
103, 104: Near-infrared blocking film
200: Transparent substrate
200A: Near-infrared blocking film laminate
201, 202: Glass film
201A, 202A: Glass film with near-infrared blocking film
203, 204: Near-infrared blocking film
205, 206: Bonding layer
207, 208: Bonding layer
300: Glass film
300A: Glass film with carrier film
301: Carrier film (interleaf film)
302: Unwinding zone
303: Conveyance zone
304: Heater zone
305: Conveyance zone
306: Surface treatment zone
307: Film forming process zone
308: Annealing zone
309: Conveyance cooling zone
310: Winding zone
311: Glass film with carrier film unwinding roll
312: Carrier film winding roll
313: Touch roll
314: Free roll
315: Tension roll
316: Motor-driven roll
317, 318: Free roll
319: Tension roll
320, 321, 322, 323: Heater
324, 325, 326, 327: Free roll
328: Motor-driven roll
329, 330: Free roll
331: Tension roll
332, 333: Surface treatment device
334: Free roll
335: Motor-driven roll
336: Process roll
337, 338, 339, 340, 341, 342, 343, 344: Sputtering cathode
345: Tension roll
346: Free roll
347: Free roll
348: Tension roll
349, 350, 351, 352: Heater
353: Driving roll
354, 355, 356: Free roll
357: Tension roll
358, 359: Free roll
360: Motor-driven cooling roll
361: Winding roll for glass film with near-infrared
blocking film with carrier film
362: Carrier film unwinding roll
363: Tension roll
364: Carrier film
365: Free roll
366: Touch roll
400: Glass film
400A: Glass film with carrier film
401: Carrier film (interleaf film)
402: Unwinding zone
403: Conveyance zone
404: Heater zone
405: Conveyance zone
406: Surface treatment zone
407: Film forming process zone
408: Annealing zone
409: Conveyance cooling zone
410: Tension adjustment zone
411: Glass film with carrier film unwinding roll
412: Carrier film winding roll
413: Touch roll
414: Free roll
415: Tension roll
416: Motor-driven roll
417, 418: Free roll
419: Tension roll
420, 421, 422, 423: Heater
424, 425, 426, 427: Free roll
428: Motor-driven roll
429, 430: Free roll
431: Tension roll
432, 433: Surface treatment device
434: Free roll
435: Motor-driven roll
436: Process roll
437, 438, 439, 440, 441, 442, 443, 444: Sputtering cathode
445: Tension roll
446: Free roll
447: Free roll
448: Tension roll
449, 450, 451, 452: Heater
453: Driving roll
454, 455, 456: Free roll
457: Tension roll
458, 459: Free roll
460: Motor-driven cooling roll
461: Free roll
462: Dancer roll
463: Tension roll
464: Differential exhaust zone
465, 466: Macaroni packing (hollow packing)
467: Cut (cutting) zone
468: Motor-driven roll
469: Nip roll
470: Laser device
471: Laser beam
472: Tray
473: Glass film with near-infrared blocking film cut (cutting) into sheet shape
500: Transparent substrate
501, 502: Glass film with near-infrared blocking film
503, 504, 505, 506: Ion beam or plasma processing device or atmospheric pressure plasma processing device or corona processing device in atmosphere
507, 508, 509, 510: Guide roll
511, 512, 513, 514: Hot roll
515: Near-infrared blocking film laminate
600: Transparent substrate
601, 602: Glass film with near-infrared blocking film
603: Hot plate
604, 605: Hot roll
606: Near-infrared blocking film laminate

## Claims

1. A glass film with a near-infrared blocking film, comprising:
a glass film having a thickness of 200 µm or less; and
a near-infrared blocking film formed on at least one side of the glass film and made of a composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) and having a hexagonal crystal structure,
**characterized in that** the maximum value of transmittance in a visible light region of a wavelength of 380 nm or more and 780 nm or less of the near-infrared blocking film is 5% or more, and reflectance at a wavelength of 1400 nm of the near-infrared blocking film is 30% or more.

2. The glass film with a near-infrared blocking film according to claim 1, **characterized in that** a film thickness of the near-infrared blocking film is 10 nm or more and 500 nm or less.

3. The glass film with a near-infrared blocking film according to claim 1 or 2, **characterized in that** a surface resistance value of the near-infrared blocking film is 10⁵ Ω/□ (ohms per square) or more.

4. The glass film with a near-infrared blocking film according to claim 1, **characterized in that** a bonding layer is formed on a surface of the near-infrared blocking film.

5. The glass film with a near-infrared blocking film according to claim 4, **characterized in that** the bonding layer is composed of an oxide selected from SiO₂, Al₂O₃, ZrO₂, TiO₂, and HfO₂.

6. A near-infrared blocking film laminate, comprising:
a transparent substrate that transmits visible light; and
the glass film with a near-infrared blocking film according to claim 1 or 4 laminated on the transparent substrate.

7. The near-infrared blocking film laminate according to claim 6, **characterized in that** the transparent substrate is composed of an inorganic material selected from plate glass or transparent ceramics, or an organic material selected from a resin film or a resin plate.

8. A method for manufacturing the glass film with a near-infrared blocking film according to claim 1, comprising:
a glass film unwinding step of unwinding a glass film having a thickness of 200 µm or less wound around an unwinding roll;
a film forming step of forming a film of composite tungsten oxide represented by the general formula MxWyOz (wherein M is one or more elements selected from K, Rb, Cs, Na, Sr, Ba, and Ti, W is tungsten, O is oxygen, 0.2 ≤ x/y ≤ 0.5, 2.5 ≤ z/y ≤ 3.0) on at least one surface of the glass film by a film forming unit while conveying the glass film unwound from the unwinding roll by a roll-to-roll method; and
a heat treatment step of heat-treating the glass film on which the composite tungsten oxide is formed at a temperature equal to or lower than a strain point of the glass film to form a near-infrared blocking film made of composite tungsten oxide having a hexagonal crystal structure.

9. The method for manufacturing a glass film with a near-infrared blocking film according to claim 8, **characterized in that**, in the heat treatment step, heat treatment is sequentially performed using a plurality of heat treatment units on the glass film on which the composite tungsten oxide is formed, and a first heat treatment unit is composed of an infrared heater that emits infrared rays having a wavelength of 1500 nm or more.

10. The method for manufacturing a glass film with a near-infrared blocking film according to claim 9, **characterized in that** the first heat treatment unit is composed of a carbon heater or a SiC heater.

11. A method for manufacturing the near-infrared blocking film laminate according to claim 6, comprising a thermocompression bonding step of thermocompression bonding the glass film with a near-infrared blocking film according to claim 1 or 4 and the transparent substrate composed of the organic material according to claim 7.

12. A method for manufacturing the near-infrared blocking film laminate according to claim 6, comprising a surface activation step of activating at least one surface of the glass film with a near-infrared blocking film according to claim 1 or 4 and the transparent substrate composed of the inorganic material according to claim 7, and a bonding step of bonding the glass film with a near-infrared blocking film and the transparent substrate via the activated surface.
